(19) Europäisches Patentamt / European Patent Office / Office européen des brevets

(11) **EP 4 614 242 A1**

(12) **DEMANDE DE BREVET EUROPEEN**

(43) Date de publication:
**10.09.2025  Bulletin 2025/37**

(21) Numéro de dépôt: **24161245.6**

(22) Date de dépôt: **04.03.2024**

(51) Classification Internationale des Brevets (IPC):
*G04B 17/06* (2006.01)   *G04D 7/08* (2006.01)
*G04D 7/10* (2006.01)   *G04D 7/12* (2006.01)
*B81C 99/00* (2010.01)

(52) Classification Coopérative des Brevets (CPC):
**G04B 17/063; G04D 7/08; G04D 7/085; G04D 7/10;
G04D 7/125; G04D 7/1285; G04D 7/1292;
B81C 99/004; B81C 99/0055**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(71) Demandeur: **Richemont International S.A.
1752 Villars-sur-Glâne (CH)**

(72) Inventeurs:
• **SOOBBARAYEN, Kévin
  25560 La Rivière-Drugeon (FR)**
• **JAN, Yannick
  25300 Pontarlier (CH)**

(74) Mandataire: **Novagraaf International SA
Chemin de l'Echo 3
1213 Onex, Geneva (CH)**

(54) **FABRICATION ET APPAIRAGE DE COMPOSANTS HORLOGERS**

(57)    Procédé de fabrication d'un oscillateur horloger (10) comprenant les étapes consistant à :
- (E10) fabriquer l'un de l'élément inertiel et de l'organe élastique de rappel,
- (E20) imposer une excitation vibratoire et mesurer une réponse vibratoire sur ledit composant fabriqué,
- (E30) prédire une inertie de l'élément inertiel fabriqué ou une raideur de l'organe élastique de rappel fabriqué :
- (E40) prévoir un appairage :

• de l'élément inertiel ayant l'inertie prédite à l'étape précédente, en déduisant une raideur cible d'un organe élastique de rappel à appairer, ou
• de l'organe élastique de rappel ayant la raideur prédite à l'étape précédente, en déduisant une inertie cible d'un l'élément inertiel nécessaire à appairer.

EP 4 614 242 A1

[Fig. 2]

**Description**

Domaine technique de l'invention

La présente invention concerne de manière générale la fabrication de composants horlogers prévus pour être appairés avec d'autres composants horlogers. Typiquement, l'invention peut concerner l'appairage de composants d'un oscillateur horloger, comme par exemple un élément inertiel, tel qu'un balancier, à accoupler avec un organe élastique de rappel, tel qu'un ressort spiral horloger, autrement appelé spiral.

État de la technique

Les mouvements de montres mécaniques sont régulés au moyen d'un régulateur mécanique comprenant un élément inertiel accouplé à un organe élastique de rappel (c'est-à-dire un composant déformable élastiquement chargé de rappeler l'élément inertiel dans une position neutre) et dont les oscillations déterminent la marche de la montre. De nombreuses montres comportent par exemple un régulateur comprenant un spiral comme organe élastique de rappel, monté sur l'axe d'un balancier supportant par ailleurs un balancier, le tout étant mis en oscillations entretenues grâce à un échappement et une ancre. La fréquence propre du couple balancier-spiral permet de réguler la montre et dépend notamment de la raideur du spiral et de l'inertie du balancier.

En effet, la fréquence f de l'organe régulateur formé par le spiral de raideur R accouplé à un balancier d'inertie I est donnée par la formule :

[équation 1]

$$f = \frac{1}{2\pi}\sqrt{\frac{R}{I}}$$

La géométrie et/ou le matériau déterminant l'inertie du balancier définissent également ses caractéristiques vibratoires intrinsèques, comme la fréquence propre et les fréquences de résonance de la pièce seule (également influencées par les conditions d'attache de la pièce). Ceci est également valable pour le spiral : sa géométrie et/ou son matériau déterminant la raideur définissent également ses caractéristiques vibratoires intrinsèques, comme la fréquence propre et les fréquences de résonance de la pièce seule.

Dans la présente demande, la fréquence propre d'un élément inertiel ou d'un couple élément inertiel/organe élastique de rappel est la fréquence à laquelle oscille ce système lorsqu'il est en évolution libre, c'est-à-dire sans force excitatrice.

Par ailleurs, une fréquence de résonance d'un système élastique (typiquement une pièce comme l'organe élastique de rappel seul ou l'élément inertiel seul qui est également intrinsèquement apte à être déformé élastiquement s'il est excité de manière ad hoc) soumis à une force excitatrice est une fréquence à laquelle on peut mesurer un maximum local d'amplitude de déplacement pour un point donné du système élastique. En d'autres termes, si le système élastique est excité avec une source d'excitation de fréquence variable au cours du temps, l'amplitude de déplacement suit une pente ascendante avant cette fréquence de résonance, et suit une pente descendante après, en tout point qui ne correspond pas à un noeud de vibration. Typiquement, lors d'un tel essai, l'enregistrement au cours du temps de l'amplitude de déplacement en fonction de la fréquence d'excitation présente au moins un pic d'amplitude de déplacement ou pic de résonance qui est associé ou qui caractérise la fréquence de résonance.

L'inertie d'un élément inertiel dépend typiquement des caractéristiques de son matériau (sa densité), ainsi que de ses dimensions. Le moment d'inertie Igz d'un solide par rapport à un axe z passant par son centre de gravité est donné plus spécifiquement par :

[Équation 2]

$$I_{gz} = \Sigma(\Delta m . r^2)$$

avec :

r, la distance d'un volume élémentaire à l'axe z
$\Delta$m, la masse du volume élémentaire.

La raideur du spiral définit également ses caractéristiques vibratoires intrinsèques, comme la fréquence propre et les fréquences de résonance. La raideur d'un résonateur de type spiral dépend typiquement des caractéristiques de matériau, ainsi que de ses dimensions et en particulier de l'épaisseur (c'est-à-dire de la largeur) de ses spires le long de son barreau. La raideur est donnée plus spécifiquement par :

$$[\text{Équation 3}]$$

$$R = \frac{M}{\varphi}$$

avec :

$\varphi$, l'angle de torsion du ressort, et
$M$, le couple de rappel du ressort spiral,
où M, pour un barreau de section constante constitué d'un matériau spécifique, est donné par :

$$[\text{Équation 4}]$$

$$M = \frac{E \left( \frac{e^3 h}{12} \varphi \right)}{L}$$

avec :

$E$, le module d'Young du matériau employé pour le barreau,
$L$, la longueur du barreau,
$h,$ la hauteur du barreau, et
e, l'épaisseur ou la largeur du barreau.

La fréquence propre de l'organe régulateur formé par le spiral de raideur R accouplé à un balancier d'inertie I est notamment proportionnelle à la racine carrée de la raideur du spiral. La spécification principale d'un ressort spiral est sa raideur, qui doit se trouver dans un intervalle bien défini pour pouvoir être appairé avec un balancier, qui forme l'élément inertiel de l'oscillateur. Cette opération d'appairage est indispensable pour régler précisément la fréquence d'un oscillateur mécanique.

Comme cela sera expliqué plus en détail ci-dessous, la température de fonctionnement est également un paramètre influent sur la marche de l'organe régulateur, on peut dériver l'équation 1 par rapport à la température T, et on trouve :

$$[\text{Équation 5}]$$

$$\frac{1}{F}\frac{dF}{dT} = \frac{1}{2}\left( \frac{1}{E(T_0)}\frac{dE}{dT} + 3\alpha_S - 2\alpha_B \right)$$

Avec :

T, la température courante,
Ta, une température de référence,
$\alpha_S$, le coefficient de dilatation thermique du spiral
$\alpha_B$, le coefficient de dilatation thermique de la serge de balancier.

On peut réécrire cette équation 5 comme ci-dessous :

[Équation 6]

$$CT = \frac{1}{2}(CTE + 3\alpha_S - 2\alpha_B)$$

Avec :

CT : le coefficient thermique de l'oscillateur (secondes par jour et par degré),
CTE : le coefficient thermique de module de Young ($K^{-1}$), ou autrement appelé coefficient thermoélastique.

Il est connu dans l'art antérieur de tester séparément et unitairement les composants à appairer entre eux avant d'effectuer concrètement l'accouplement. En contrepartie, cette manière d'appairage peut présenter des inconvénients liés à la mesure qui peut être longue, fastidieuse, source d'erreurs, de pollutions, de casses.

Par ailleurs, pour pouvoir garantir des performances de l'assemblage acceptables (c'est-à-dire conformes à un cahier des charges incluant notamment des variations de marche (par jour, par position de test ou d'utilisation ou en fonction de la température) à ne pas dépasser), il apparaît que les composants unitaires doivent tout d'abord répondre à des critères stricts.

Ainsi, les composants unitaires doivent typiquement pouvoir être classés dans des classes particulières (selon une inertie cible pour l'élément inertiel, tel qu'un balancier, ou selon une raideur cible pour l'organe élastique de rappel, tel qu'un ressort spiral horloger, ou encore selon des paramètres thermiques), les classes prévoyant un intervalle de tolérance autour d'une valeur cible. Les balanciers d'une classe donnée sont destinés à être accouplés à des spiraux d'une classe correspondante, permettant d'obtenir une fréquence de l'organe régulateur assemblé qui soit proche de celle attendue et qui puisse être corrigée avec les moyens de réglages présents dans le mouvement ou sur le balancier. Compte-tenu des plages de tolérance de chaque classe, une étape de réglage est réalisée pour ajuster la fréquence de l'organe régulateur pour atteindre la fréquence attendue.

Il apparaît que la fabrication de composants horlogers pour qu'ils puissent effectivement appartenir à une classe et être ensuite accouplés à un composant complémentaire nécessite des procédés de fabrication très précis, des tolérances serrées et on peut constater que certains composants doivent être écartés car non conformes. Le classement et le réglage qui doivent être effectués sont des opérations délicates et chronophages. Toutes ces contraintes peuvent rendre les procédés de fabrication complexes et onéreux, ou peuvent rendre obligatoire la constitution de stocks de pièces.

Exposé de l'invention

Un but de la présente invention est de répondre aux inconvénients de l'art antérieur mentionnés ci-dessus et en particulier, tout d'abord, de proposer un procédé de fabrication d'un oscillateur horloger devant présenter une fréquence d'oscillation prédéterminée et comprenant un élément inertiel, tel qu'un balancier, accouplé à un organe élastique de rappel, tel qu'un ressort spiral horloger, qui soit plus simple et/ou moins onéreux et/ou dont le taux de rebut est plus faible que les procédés connus, et/ou qui ne nécessitent pas la constitution de stocks de pièces en vue d'un classement ou d'un appairage.

Pour cela un premier aspect de l'invention concerne un procédé de fabrication d'un oscillateur horloger devant présenter une fréquence d'oscillation prédéterminée et comprenant un élément inertiel, tel qu'un balancier, accouplé à un organe élastique de rappel, tel qu'un ressort spiral horloger, le procédé de fabrication comprenant les étapes consistant à :

- fabriquer au moins partiellement au moins l'un :

  • de l'élément inertiel et

  • de l'organe élastique de rappel,

- imposer une excitation vibratoire au dit au moins l'un :

  • de l'élément inertiel dans un état non-accouplé et
  • de l'organe élastique de rappel dans un état non-accouplé,

- mesurer une réponse vibratoire :

- de l'élément inertiel non-accouplé et prédire une inertie de l'élément inertiel avec une machine de prédiction d'inertie, ou
- de l'organe élastique de rappel non-accouplé et prédire une raideur de l'organe élastique de rappel avec une machine de prédiction de raideur,

- prévoir un appairage :

- de l'élément inertiel ayant l'inertie prédite à l'étape précédente, en déduisant une raideur cible de l'organe élastique de rappel nécessaire pour obtenir la fréquence d'oscillation prédéterminée, et obtenir un organe élastique de rappel à appairer ayant la raideur cible en fabriquant un organe élastique de rappel ou en apportant une correction géométrique à un organe élastique de rappel déjà fabriqué, ou
- de l'organe élastique de rappel ayant la raideur prédite à l'étape précédente, en déduisant une inertie cible de l'élément inertiel nécessaire pour obtenir la fréquence d'oscillation prédéterminée, et obtenir un élément inertiel à appairer ayant l'inertie cible en fabriquant un élément inertiel ou en apportant une correction géométrique à un élément inertiel déjà fabriqué.

Selon la mise en oeuvre ci-dessus, dans le cadre d'un assemblage de deux composants horlogers, il est prévu de fabriquer un premier des composants à accoupler, de mesurer ou prédire au moins l'une de ses caractéristiques essentielles pour la bonne marche de l'oscillateur, et de prédire une cible pour au moins l'une de des caractéristiques essentielles du deuxième composant (ou composant complémentaire) pour la bonne marche de l'assemblage (ici et en particulier l'oscillateur) avant de fabriquer ledit deuxième composant (ou composant complémentaire). Ainsi, il est possible de fabriquer ledit deuxième composant (ou composant complémentaire) selon des spécifications adaptées, ou sur mesure, pour obtenir la cible désirée, et avoir un composant complémentaire parfaitement adapté au premier composant fabriqué. On peut alors garantir un fonctionnement plus précis qu'avec des composants fabriqués selon les procédés de l'art antérieur et classés avant d'être appairés. On peut aussi prévoir des tolérances plus larges pour la fabrication du premier composant, puisque le composant complémentaire sera fabriqué avec des spécifications adaptées pour obtenir la cible désirée et prédite à partir des mesures et prédictions effectuées sur le premier composant. Enfin, on comprend que les stocks sont réduits ou supprimés, car la fabrication du deuxième composant est effectuée à la demande, une fois le premier composant testé. En d'autres termes, on peut noter que selon l'invention, un deuxième composant, à appairer à un premier composant déjà fabriqué, est fabriqué selon des spécifications (uniques et ajustées) prédites en fonction de caractéristiques mesurées sur le premier composant.

Le procédé de fabrication peut comprendre ou présenter les caractéristiques suivantes, prises individuellement ou en combinaison.

Selon une mise en oeuvre, le procédé de fabrication comprend une étape consistant à appairer ou accoupler :

- l'élément inertiel ayant ladite inertie prédite avec l'organe élastique de rappel ayant la raideur cible, ou
- l'organe élastique de rappel ayant ladite raideur prédite avec l'élément inertiel ayant l'inertie cible.

Selon une mise en oeuvre, le procédé de fabrication comprend une étape, effectuée sur l'élément inertiel dans un état non-accouplé ou sur l'organe élastique dans un état non-accouplé, consistant à corriger :

- une inertie de l'élément inertiel ayant subi l'excitation vibratoire dans un état non-accouplé, ou
- une raideur de l'organe élastique de rappel ayant subi l'excitation vibratoire dans un état non-accouplé. Selon la mise en oeuvre ci-dessus, une étape de correction ou de modification sur le premier composant fabriqué n'est pas exclue, pour par exemple pouvoir fabriquer le composant complémentaire selon des spécification préférées et/ou pouvant être conduites plus facilement.

Selon une mise en oeuvre, la fabrication de l'élément inertiel et/ou de l'organe élastique de rappel comprend une étape de gravure d'un substrat non-métallique pour former au moins une partie de l'élément inertiel et/ou de l'organe élastique de rappel dans une matière non-métallique. En particulier, l'élément inertiel et/ou l'organe élastique de rappel peut être au moins partiellement réalisé en silicium, en carbone, en quartz, en verre, ou même être une pièce au moins partiellement composite. Dans le cas de composants en silicium, on peut prévoir une étape de gravure ionique réactive profonde.

En particulier, et selon une mise en oeuvre, la fabrication de l'élément inertiel et/ou de l'organe élastique de rappel comprend une étape de gravure de l'élément inertiel et/ou de l'organe élastique de rappel dans une plaquette en silicium.

Selon une mise en oeuvre, l'étape d'excitation vibratoire dans un état non-accouplé de l'élément inertiel et/ou de l'organe élastique de rappel est effectuée avec l'élément inertiel et/ou l'organe élastique de rappel encore attaché à un substrat de matière première de l'élément inertiel et/ou de l'organe élastique de rappel. Le procédé de fabrication est simplifié, car le composant déjà fabriqué est encore attaché à son substrat de base, si bien que les risques de casse, pollution, erreur de positionnement sont réduits. On peut aussi mesurer, de préférence à des instants séparés, plusieurs pièces attachées à un même substrat.

Selon une mise en oeuvre, l'étape d'excitation vibratoire dans un état non-accouplé de l'élément inertiel et/ou de l'organe élastique de rappel est effectuée avant détachement ou libération ou dégrappage de l'élément inertiel et/ou de l'organe élastique de rappel d'un substrat de matière première de l'élément inertiel et/ou de l'organe élastique de rappel. Autrement dit, l'étape de mesure/prédiction des caractéristiques essentielles du premier composant déjà fabriqué sont effectuées avant la toute fin du processus de fabrication. La prédiction des caractéristiques cibles de fabrication pour le deuxième composant ou composant complémentaire sont donc disponibles rapidement, si bien que la fabrication du deuxième composant ou composant complémentaire peut démarrer avant la fin du processus de fabrication du premier composant.

Selon une mise en oeuvre, l'étape de fabrication de l'élément inertiel et/ou de l'organe élastique de rappel, commencée avant l'étape d'excitation vibratoire, est terminée ou achevée après l'étape d'excitation vibratoire.

Selon une mise en oeuvre :

- l'étape consistant à obtenir un organe élastique de rappel à appairer ayant la raideur cible comprend une étape consistant à ajouter ou retirer de la matière d'un organe élastique de rappel déjà fabriqué, ou
- l'étape consistant à obtenir un élément inertiel à appairer ayant l'inertie cible comprend une étape consistant à ajouter ou retirer de la matière d'un élément inertiel déjà fabriqué. Selon la mise en oeuvre ci-dessus, le deuxième composant, ou composant complémentaire, est retouché pour obtenir les caractéristiques cibles.

Selon une mise en oeuvre, l'étape d'excitation vibratoire est effectuée en plaçant l'élément inertiel dans un état non-accouplé ou l'organe élastique de rappel dans un état non-accouplé en regard d'une source d'excitation acoustique. Autrement dit, l'étape d'excitation vibratoire est effectuée sur l'élément inertiel seul (encore attaché à un substrat de base ou bridé sur un outillage de mesure) ou sur l'organe élastique de rappel seul (encore attaché à un substrat de base ou bridé sur un outillage de mesure).

Selon une mise en oeuvre, l'étape d'excitation vibratoire est effectuée en appliquant à l'élément inertiel dans un état non-accouplé ou à l'organe élastique de rappel dans un état non-accouplé une excitation vibratoire variable au cours du temps pour couvrir une plage fréquentielle prédéterminée.

Selon une mise en oeuvre, la plage fréquentielle s'étend sur une plage de fréquence allant de 0 Hz à 500 kHz, et/ou de 0 Hz à 100 kHz, et/ou de 100 kHz à 200 kHz, et/ou de 200 kHz à 300 kHz, et/ou de 300 kHz à 400 kHz, et/ou de 400 kHz à 500 kHz, de préférence de 5 kHz à 150 kHz, plus préférentiellement de 5 kHz à 100 kHz, et très préférentiellement de 10 kHz à 80 kHz.

Selon une mise en oeuvre, l'étape de mesure d'une réponse vibratoire comprend une étape consistant à identifier au moins une caractéristique de fréquence de résonance, telle qu'un pic de résonance, de l'élément inertiel dans un état non-accouplé ou de l'organe élastique de rappel dans un état non-accouplé, lors de l'excitation vibratoire ou en réponse à l'excitation vibratoire.

Selon une mise en oeuvre :

- l'étape de prédiction de l'inertie de l'élément inertiel avec une machine de prédiction d'inertie, ou
- l'étape de prédiction de la raideur de l'organe élastique de rappel avec une machine de prédiction de raideur,

est effectuée avec la mise en oeuvre d'une formule polynomiale, et/ou avec la mise en oeuvre d'une classification effectuée par exemple par un réseau de neurones et/ou avec la mise en oeuvre d'une classification basée sur un partitionnement en k-moyennes ou en k-médianes. Autrement dit, la machine de prédiction d'inertie et/ou la machine de prédiction de raideur peut comprendre une unité de calcul prévue pour appliquer ou utiliser une formule polynomiale, et/ou une classification effectuée par exemple par un réseau de neurones et/ou une classification basée sur un partitionnement en k-moyennes ou en k-médianes. On entend par machine de prédiction une unité de prédiction avec des moyens de calcul, des moyens de mémoire, et prévue pour recevoir en entrée des données de mesure de la réponse vibratoire (les pics ou fréquences de résonance) et donner en sortie une caractéristique de la pièce testée (inertie et/ou raideur et/ou paramètre thermique tel que coefficient de dilatation thermique, coefficient thermique du module de Young...). Une telle machine de prédiction peut aussi comprendre des moyens d'apprentissage utilisés dans une phase préliminaire d'apprentissage pendant laquelle on fournit des données d'apprentissage. Les données d'apprentissage peuvent typiquement comprendre des résultats de test vibratoire, des résultats de mesures effectuées sur les mêmes pièces que celle soumises à une excitation vibratoire, pour mesurer une caractéristique de la pièce testée (inertie et/ou raideur et/ou paramètre thermique tel que coefficient de dilatation thermique, coefficient thermique du module de Young...), des données de simulation (réponses vibratoires, dimensions, caractéristiques de la pièce simulée telle que inertie et/ou raideur et/ou paramètre thermique tel que coefficient de dilatation thermique, coefficient thermique du module de Young...).

Selon une mise en oeuvre :

- l'étape consistant à obtenir un organe élastique de rappel à appairer ayant la raideur cible, ou
- l'étape consistant à obtenir un élément inertiel à appairer ayant l'inertie cible,

est effectuée après respectivement :

- l'étape consistant à prédire une inertie de l'élément inertiel avec une machine de prédiction d'inertie, ou
- l'étape consistant à prédire une raideur de l'organe élastique de rappel avec une machine de prédiction de raideur.

Selon une mise en oeuvre, le procédé de fabrication comprend les étapes consistant à :

- fabriquer sur une première plaquette :

  - une pluralité d'éléments inertiels ou
  - une pluralité d'organes élastiques de rappel,

- imposer l'excitation vibratoire et faire la mesure de la réponse vibratoire :

  - sur au moins une partie de la pluralité d'éléments inertiels attachés à la première plaquette, de sorte à prédire une inertie pour chacun de la pluralité d'éléments inertiels et déduire une raideur cible de l'organe élastique de rappel nécessaire pour obtenir la fréquence d'oscillation prédéterminée ou
  - sur au moins une partie de la pluralité d'organes élastiques de rappel attachés à la première plaquette de sorte à prédire une raideur pour chacun de la pluralité d'organes élastiques de rappel et déduire une inertie cible de l'élément inertiel nécessaire pour obtenir la fréquence d'oscillation prédéterminée pour chacun de la pluralité d'organes élastiques de rappel,

- prévoir un appairage :

  - pour chacun de la pluralité d'éléments inertiels ayant l'inertie prédite à l'étape précédente, en déduisant une raideur cible de l'organe élastique de rappel nécessaire pour obtenir la fréquence d'oscillation prédéterminée, ou
  - pour chacun de la pluralité d'organes élastiques de rappel ayant la raideur prédite à l'étape précédente, en déduisant une inertie cible de l'élément inertiel nécessaire pour obtenir la fréquence d'oscillation prédéterminée,

- fabriquer, de préférence sur une deuxième plaquette :

  - une pluralité d'organes élastiques de rappel où de préférence chaque organe élastique de rappel est agencé sur la deuxième plaquette à une position correspondante à une position sur la première plaquette de l'élément inertiel prévu pour son appairage, ou
  - une pluralité d'éléments inertiels où de préférence chaque élément inertiel est agencé sur la deuxième plaquette à une position correspondante à une position sur la première plaquette de l'organe élastique de rappel prévu pour son appairage.

Selon la mise en oeuvre ci-dessus, dans le cas où plusieurs premiers composants sont fabriqués sur une première plaquette support, on peut prévoir de cartographier la première plaquette support, et de prédire pour chaque premier composant (ou pour des secteurs de la première plaquette) des caractéristiques cibles à obtenir pour le deuxième composant à appairer, et fabriquer les deuxièmes composants selon un processus adapté pour obtenir lesdites caractéristiques cibles. De préférence, on peut fabriquer les deuxièmes composants complémentaires sur une deuxième plaquette, de préférence à des localisations correspondantes (typiquement selon des axes X-Y de la plaquette) aux premiers composants. Ainsi, en mettant en regard les deux plaquettes les composants à appairer sont en regard les uns des autres.

Selon une mise en oeuvre, le procédé de fabrication comprend une étape consistant à mettre en regard la première plaquette avec la deuxième plaquette pour prépositionner chaque composant de la première plaquette en regard du composant à appairer correspondant de la deuxième plaquette. On peut alors prévoir par exemple de mettre en regard de manière séquentielle la première plaquette puis la deuxième plaquette en face d'un même dispositif de rangement ayant autant de compartiments que de composants sur les plaquettes. Pour chaque plaquette, on peut détacher chaque composant dans un casier dédié. En conséquence, à l'issue de ce processus de détachement, chaque compartiment du dispositif de rangement contient le premier composant et le deuxième composant qui sont à appairer ensemble. La fabrication de l'assemblage horloger est facilitée avec des flux logistiques simplifiés.

Selon une mise en oeuvre, le procédé de fabrication comprend une étape consistant à :

- associer ou assembler au moins un composant de la première plaquette encore attaché à la première plaquette avec le composant à appairer correspondant de la deuxième plaquette, et de préférence encore attaché à la deuxième plaquette, ou
- détacher au moins un composant de la première plaquette et le composant à appairer correspondant de la deuxième plaquette pour les associer.

Un deuxième aspect de l'invention se rapporte à un procédé de fabrication d'un oscillateur horloger devant présenter une fréquence d'oscillation prédéterminée et/ou un coefficient thermique (CT) d'oscillateur prédéterminé, et comprenant un élément inertiel, tel qu'un balancier, accouplé à un organe élastique de rappel, tel qu'un ressort spiral horloger, le procédé de fabrication comprenant les étapes consistant à :

- fabriquer au moins partiellement au moins l'un :

    • de l'élément inertiel et

    • de l'organe élastique de rappel,

- imposer une excitation vibratoire au dit au moins l'un :

    • de l'élément inertiel dans un état non-accouplé et
    • de l'organe élastique de rappel dans un état non-accouplé,

- mesurer une réponse vibratoire :

    • de l'élément inertiel non-accouplé et prédire un coefficient de dilatation thermique de l'élément inertiel avec une machine de prédiction de coefficient thermique, et/ou
    • de l'organe élastique de rappel non-accouplé et prédire un coefficient thermique du module de Young (CTE) de l'organe élastique de rappel et/ou un coefficient de dilatation thermique de l'organe élastique de rappel avec une machine de prédiction de coefficient thermique,

- prévoir un appairage :

    • de l'élément inertiel ayant le coefficient de dilatation thermique prédit à l'étape précédente, en déduisant un coefficient thermique du module de Young (CTE) cible de l'organe élastique de rappel et/ou un coefficient de dilatation thermique cible de l'organe élastique de rappel pour obtenir le coefficient thermique (CT) d'oscillateur prédéterminé, et obtenir un organe élastique de rappel à appairer ayant le coefficient thermique du module de Young (CTE) cible et/ou le coefficient de dilatation thermique cible de l'organe élastique de rappel en fabriquant un organe élastique de rappel ou en apportant une correction géométrique à un organe élastique de rappel déjà fabriqué, ou
    • de l'organe élastique de rappel ayant le coefficient thermique du module de Young (CTE) et/ou le coefficient de dilatation thermique prédit à l'étape précédente, en déduisant un coefficient de dilatation thermique cible de l'élément inertiel pour obtenir le coefficient thermique (CT) d'oscillateur prédéterminé, et obtenir un élément inertiel à appairer ayant le coefficient de dilatation thermique cible en fabriquant un élément inertiel ou en apportant une correction géométrique à un élément inertiel déjà fabriqué.

Selon la mise en oeuvre ci-dessus, dans le cadre d'un assemblage de deux composants horlogers, il est prévu de fabriquer un premier des composants à accoupler, de mesurer ou prédire au moins l'une de ses caractéristiques thermiques essentielles pour la bonne marche de l'oscillateur même si la température varie, et de prédire une cible pour au moins l'une des caractéristiques thermiques essentielles du deuxième composant (ou composant complémentaire) garantissant la bonne marche de l'assemblage (ici en particulier l'oscillateur) avant de fabriquer ledit deuxième composant (ou composant complémentaire). Ainsi, il est possible de fabriquer ledit deuxième composant (ou composant complémentaire) selon des spécifications adaptées pour obtenir la cible désirée, et avoir un composant complémentaire parfaitement adapté au premier composant fabriqué, ou qui compense les variations du premier composant lors des changements de température. On peut alors garantir un fonctionnement plus précis, même si la température varie, qu'avec des composants fabriqués selon les procédés de l'art antérieur et classés avant d'être appairés. On peut aussi prévoir des tolérances plus larges pour la fabrication du premier composant, puisque le composant complémentaire sera fabriqué avec des spécifications adaptées pour obtenir la cible désirée et prédite à partir des mesures et prédictions effectuées sur le premier composant. Enfin, on comprend que les stocks peuvent être réduits ou supprimés, car la fabrication du deuxième composant est effectuée à la demande, une fois le premier composant testé. En d'autres termes, on peut noter que selon l'invention, un deuxième composant, à appairer à un premier composant déjà fabriqué, est fabriqué selon des spécifications (uniques et ajustées) prédites en fonction de caractéristiques thermiques mesurées sur le premier composant.

Description des figures

D'autres caractéristiques et avantages de la présente invention apparaîtront plus clairement à la lecture de la description détaillée qui suit de mode(s) de réalisation de l'invention donné(s) à titre d'exemple(s) nullement limitatif(s) et illustré(s) par les dessins annexés, dans lesquels :

[Fig. 1] représente un assemblage horloger, ici un oscillateur, fabriqué selon le procédé de fabrication de l'invention, et comprenant un premier composant horloger et un deuxième composant horloger appairés ;

[Fig. 2] représente un diagramme simplifié du procédé de fabrication selon l'invention ;

[Fig. 3] représente schématiquement un test vibratoire effectué sur un premier composant horloger (ici un balancier) fabriqué sur une plaquette avec d'autres premiers composants horlogers tous destinés à être assemblés pour former des assemblages horlogers de la figure 1 ;

[Fig. 4] représente schématiquement un test vibratoire effectué sur un deuxième composant horloger (ici un spiral) fabriqué sur une plaquette avec d'autres deuxièmes composants horlogers tous destinés à être assemblés pour former des assemblages horlogers de la figure 1 ;

[Fig. 5] représente un profil vibratoire pouvant être utilisé pour exciter les composants horlogers lors des tests des figures 3 ou 4 ;

[Fig. 6] représente un exemple de réponse vibratoire mesurée sur un composant horloger lors du test de la figure 3 ou 4 ;

[Fig. 7] représente en détail un pic de résonance identifié à une fréquence particulière sur la figure 6 ;

[Fig. 8] représente des pics de résonance correspondants à la fréquence particulière de la figure 7, superposés et mesurés pour plusieurs composants horlogers différents ;

[Fig. 9] représente un exemple de modèle de prédiction d'inertie construit à partir de données d'apprentissage et pouvant être utilisé par une machine de prédiction d'inertie pour prédire une inertie d'un balancier après le test de la figure 3 ;

[Fig. 10] représente un exemple de modèle de prédiction de raideur construit à partir de données d'apprentissage et pouvant être utilisé par une machine de prédiction de raideur pour prédire une raideur d'un spiral après le test de la figure 4 ;

[Fig. 11] représente l'influence de la température sur la fréquence de résonance d'un mode de résonance particulier pour l'un du balancier ou du spiral de l'assemblage horloger de la figure 1,

[Fig. 12] représente l'influence des composants d'un oscillateur sur la marche d'une pièce d'horlogerie, en fonction de la température.

Description détaillée de mode(s) de réalisation

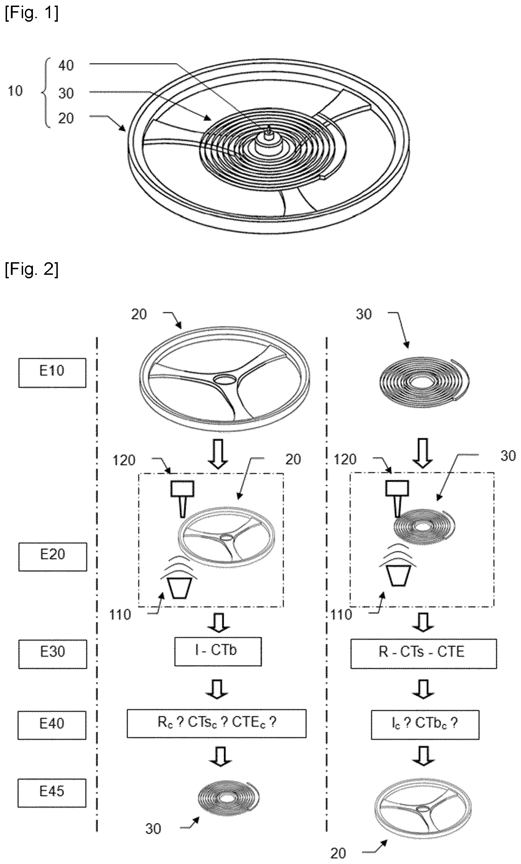

La figure 1 représente un assemblage horloger, ici un oscillateur 10, fabriqué selon le procédé de fabrication de l'invention, et comprenant un premier composant horloger, ici un balancier 20, et un deuxième composant horloger, ici un

EP 4 614 242 A1

organe élastique de rappel, un spiral 30, montés sur un axe de balancier 40 et appairés pour que l'oscillateur 10 présente une fréquence d'oscillations libres prédéterminée (par exemple 2 Hz, ou 3Hz, ou encore 4Hz).

Comme indiqué ci-dessus dans le passage concernant les explications relatives à l'équation 1, la fréquence f de l'oscillateur 10, comprenant le spiral 30 et le balancier 20, dépend notamment de l'inertie I du balancier 20 et de la raideur R du spiral 30. Il convient donc de garantir que les composants horlogers (balancier 20 et spiral 30) une fois accouplés formeront un oscillateur 10 dont la fréquence libre d'oscillation sera celle désirée.

A cet effet, la figure 2 représente un diagramme simplifié d'un procédé de fabrication selon l'invention qui permet de fabriquer un oscillateur 10 dont la fréquence libre d'oscillation sera celle désirée.

Dans le cas où on dispose d'un balancier 20 déjà au moins partiellement fabriqué, la situation est celle de la colonne du milieu de la figure 2, et le procédé de fabrication peut comprendre les étapes suivantes :

- étape E10 : fabriquer au moins partiellement le balancier 20,
- étape E20 : imposer une excitation vibratoire au balancier 20 dans un état non-accouplé avec une source d'excitation vibratoire 110 (ici une source acoustique) et mesurer une réponse vibratoire du balancier 20 avec un instrument de mesure de vibrations 120 (par exemple un vibromètre laser),
- étape E30 : prédire une inertie I et/ou un coefficient de dilatation thermique CTb du balancier 20 avec une machine de prédiction d'inertie et/ou avec une machine de prédiction thermique,
- étape E40 : prévoir un appairage du balancier 20 ayant l'inertie I prédite et/ou le coefficient de dilatation thermique CTb prédit à l'étape précédente, en déduisant une raideur cible $R_c$ et/ou un coefficient de dilatation thermique cible $CTs_c$ et/ou un coefficient thermique de module de Young cible $CTE_c$ du spiral 30 nécessaire pour obtenir la fréquence d'oscillation prédéterminée d'un oscillateur intégrant le balancier 20 déjà fabriqué et un spiral 30 à appairer,
- étape E45 : obtenir un spiral 30 à appairer ayant la raideur cible $R_c$ et/ou le coefficient de dilatation thermique cible $CTs_c$ et/ou le coefficient thermique de module de Young cible $CTE_c$ en fabriquant le spiral 30 ou en apportant une correction géométrique à un spiral 30 déjà fabriqué ou partiellement fabriqué.

Dans le cas où on dispose d'un spiral 30 déjà au moins partiellement fabriqué, la situation est celle de la colonne de droite de la figure 2, et le procédé de fabrication peut comprendre les étapes consistant à :

- étape E10 : fabriquer au moins partiellement le spiral 30,
- étape E20 : imposer une excitation vibratoire au spiral 30 dans un état non-accouplé avec une source d'excitation vibratoire 110 (ici une source acoustique) et mesurer une réponse vibratoire du spiral 30 avec un instrument de mesure de vibrations 120,
- étape E30 : prédire une raideur R et/ou un coefficient de dilatation thermique CTs et/ou un coefficient thermique de module de Young CTE du spiral 30 avec une machine de prédiction de raideur et/ou avec une machine de prédiction thermique,
- étape E40 : prévoir un appairage du spiral 30 ayant la raideur R prédite et/ou le coefficient de dilatation thermique CTs prédit et/ou le coefficient thermique de module de Young CTE prédit à l'étape précédente, en déduisant une inertie cible $I_c$ et/ou un coefficient de dilatation thermique cible $CTb_c$ du balancier 20 nécessaire pour obtenir la fréquence d'oscillation prédéterminée d'un oscillateur intégrant le spiral 30 et un balancier 20 à appairer,
- étape E45 : obtenir un balancier 20 à appairer ayant l'inertie cible $I_c$ et/ou le coefficient de dilatation thermique cible $CTb_c$ en fabriquant le balancier 20 ou en apportant une correction géométrique à un balancier 20 déjà fabriqué ou partiellement fabriqué.

Ainsi, à partir d'un des deux composants de l'oscillateur 10 déjà (au moins partiellement) fabriqué, le procédé propose de faire une mesure vibratoire pour prédire au moins une des caractéristiques essentielles (du composant déjà fabriqué) qui pilotent la fréquence d'oscillation ou le comportement thermique de l'oscillateur 10, afin de pouvoir déduire au moins l'une des caractéristiques essentielles de l'autre composant non encore fabriqué, si bien qu'il est possible de planifier une fabrication ajustée ou une retouche ajustée qui conduira à obtenir l'autre composant « sur-mesure » ou « personnalisé » ou encore « ajusté ». Ainsi, l'autre composant fabriqué « sur mesure » peut être appairé et accouplé au composant initialement fabriqué et on obtiendra une marche de l'oscillateur 10 conforme au cahier des charges. Une telle fabrication sur mesure permet de ne pas faire de classement des pièces, ni de stock de pièces.

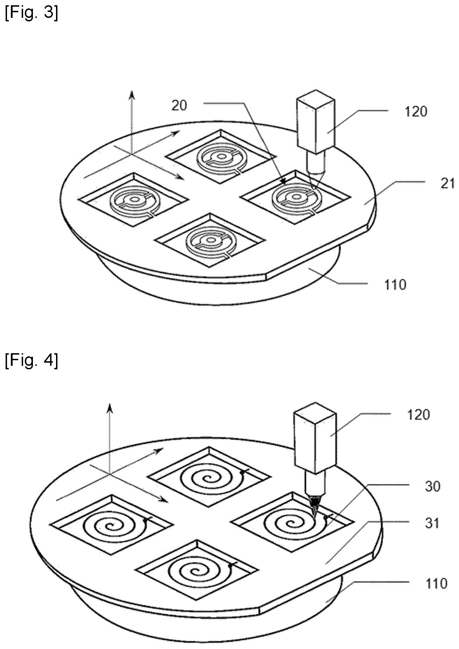

La figure 3 représente schématiquement un test vibratoire effectué sur un premier composant horloger (ici un balancier 20) fabriqué sur une plaquette avec d'autres premiers composants horlogers (d'autres balanciers 20) tous destinés à être assemblés pour former des assemblages horlogers de la figure 1.

Dans le détail et dans cet exemple particulier, une plaquette 21 en silicium supporte plusieurs ébauches de balanciers. Une source vibratoire 110 supporte la plaquette 21 et peut ainsi imposer une excitation vibratoire aux ébauches de balancier de la plaquette 21. Une ébauche de balancier 20 se trouve par ailleurs en regard d'un instrument de mesure vibratoire 120 (par exemple une source laser) qui peut mesurer des déplacements, et/ou des vitesses et/ou des accélération de points particuliers de l'ébauche de balancier 20. Ainsi, lorsque la source vibratoire 110 est mise en fonctionnement, l'instrument de mesure vibratoire 120 peut mesurer une réponse vibratoire de l'ébauche de balancier 20.

On peut toutefois prévoir de brider un balancier 20 terminé dans une pince pour effectuer un test vibratoire tout à fait semblable à celui de la figure 3, pour tester par exemple des balanciers conventionnels obtenus par décolletage par exemple.

La figure 4 représente schématiquement un test vibratoire effectué sur un deuxième composant horloger (ici un spiral 30) fabriqué sur une plaquette 31 en silicium avec d'autres deuxièmes composants horlogers tous destinés à être assemblés pour former des assemblages horlogers de la figure 1.

De manière tout à fait analogue avec le test de la figure 3, la paquette 31 porte plusieurs ébauches de spiraux 30, et une source vibratoire 110 supporte la plaquette 31 pour imposer une séquence vibratoire aux composants horlogers. L'instrument de mesure vibratoire 120 est agencé en regard d'une ébauche de spiral 30 pour mesurer la réponse vibratoire.

On peut toutefois prévoir de brider un spiral 30 terminé dans une pince ou via son oeillet central ou sa virole pour effectuer un test vibratoire tout à fait semblable à celui de la figure 4, pour tester par exemple des spiraux conventionnels en métal par exemple.

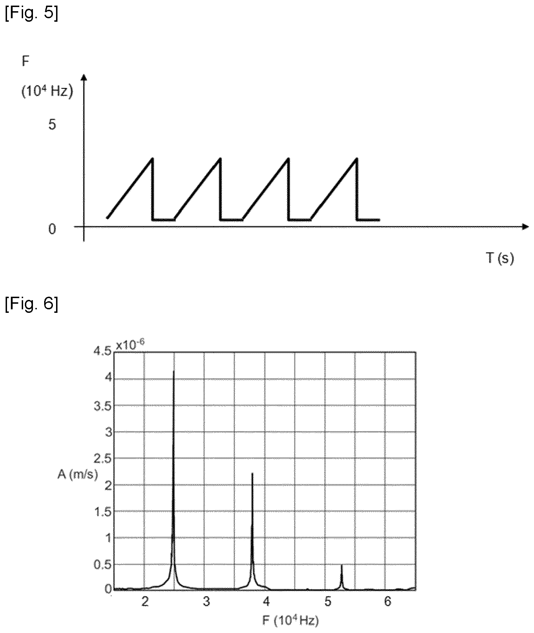

La figure 5 représente un exemple d'excitation vibratoire au cours du temps imposée par la source vibratoire 110. Dans l'exemple donné, la fréquence d'excitation varie au cours du temps, entre 0 Hz et 50 kHz à titre d'exemple, et on peut imposer une succession de fronts montants, chacun espacé d'une période de repos sans excitation. Pour chaque point de mesure sur la pièce à mesurer, on peut imposer une pluralité de front montants (entre 2 fronts montants et 60 fronts montants), chacun durant entre 0.5 s et 2 s par exemple. En fonction des pièces et des appareils de mesure de la réponse vibratoire, on pourra adapter la forme de la sollicitation vibratoire (fréquence minimale, maximale, pente de montée, de descente, nombre de répétitions...).

La figure 6 représente un exemple de spectre vibratoire reconstruit à partir des mesures d'amplitude de déplacement d'un point de mesure considéré sur un des composants horlogers lors des tests des figures 3 ou 4, en réponse à l'excitation vibratoire de la figure 5, entre 15 kHz et 65 kHz. On peut noter la présence de trois pics d'amplitude, à environ 25 kHz, 37 kHz, et 53 kHz. Bien que cela ne soit pas représenté, on peut typiquement identifier entre 10 et 30 pics d'amplitude si l'excitation vibratoire balaye une plage de fréquence comprise entre 0 Hz et 50 kHz. Chaque pic d'amplitude possède une fréquence de résonance, et les amplitudes maximales varient fortement. Ces pics de résonance peuvent représenter des modes de résonance particuliers, dans le plan de la pièce, ou hors plan.

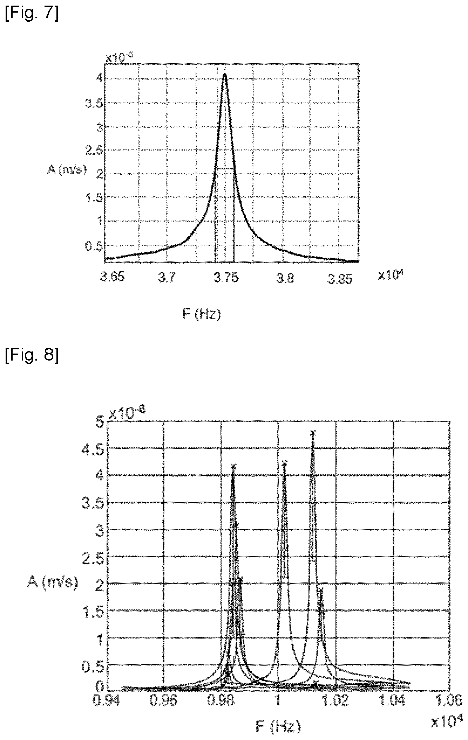

La figure 7 représente en détail un pic de résonance identifié à une fréquence particulière sur la figure 6. Cette figure 7 représente en détail le traitement que l'on peut faire sur un pic d'amplitude, celui à 37.5 kHz par exemple. Le but est de trouver la fréquence de résonance et de lui donner une valeur aussi précise que possible. Au lieu de baser ce traitement sur la valeur maximale du pic, la demanderesse s'est aperçue qu'une meilleure précision pouvait être atteinte en déterminant la longueur du segment reliant la partie montante et la partie descendante de la courbe, à mi-hauteur du pic. La fréquence de résonance étant typiquement la valeur au milieu de ce segment. Cependant, on peut effectuer une interpolation sur des points au voisinage du pic de résonance pour améliorer la précision, et décaler le point choisi sur le segment, qui ne sera pas le milieu, en particulier si la position réelle du pic de résonance est décalée par exemple en raison de la fréquence d'échantillonnage choisie.

La figure 8 représente, pour l'exemple d'un pic d'amplitude à 37 kHz environ, les pics d'amplitudes construits pour une dizaine d'ébauches de composants horlogers (ici des spiraux 30) testées. On peut noter que d'une ébauche de spiral 30 à l'autre, la position en fréquence du pic d'amplitude varie (de 37 kHz à 38 kHz environ), et que l'amplitude maximale de déplacement varie dans un rapport de 1 à 5 environ. Les sommets de pics d'amplitude n'étant pas vraiment symétriques, il apparaît judicieux de déterminer la fréquence de résonance sur la base de la largeur du pic à mi-hauteur.

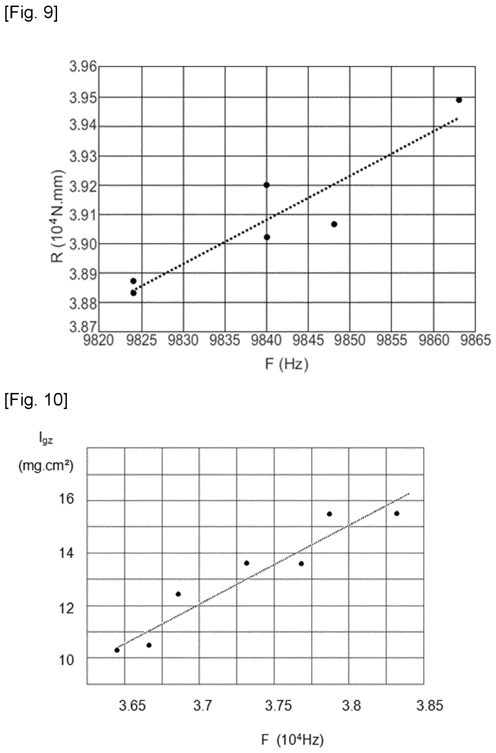

La figure 9 représente un exemple de modèle de prédiction de raideur construit à partir de données d'apprentissage et pouvant être utilisé par une machine de prédiction de raideur pour prédire une raideur d'un spiral après le test de la figure 4. En particulier, on peut prévoir une phase d'apprentissage pour construire un tel modèle de prédiction. Une telle phase d'apprentissage peut comprendre les étapes suivantes :

- effectuer des tests vibratoires sur des pièces réelles (des spiraux fabriqués représentatifs des pièces qui seront fabriquées et testées ultérieurement), ou des simulations, pour identifier des pics de résonance,
- mesurer physiquement les pièces testées pour mesurer une raideur (sur un appareil de mesure de couple par exemple), ou pour mesurer des dimensions permettant de calculer la raideur de chaque pièce, on encore faire des simulations pour calculer la raideur,
- construire le modèle de prédiction en associant les pics de résonance identifiés avec la raideur calculée ou mesurée.

La figure 10 représente un exemple de modèle de prédiction d'inertie construit à partir de données d'apprentissage et pouvant être utilisé par une machine de prédiction d'inertie pour prédire une inertie d'un balancier 20 après le test de la figure 3. De la même manière que pour les spiraux, un tel modèle peut être construit après une phase d'apprentissage au cours de laquelle on mesure des inerties et des fréquences de résonance sur des mêmes pièces.

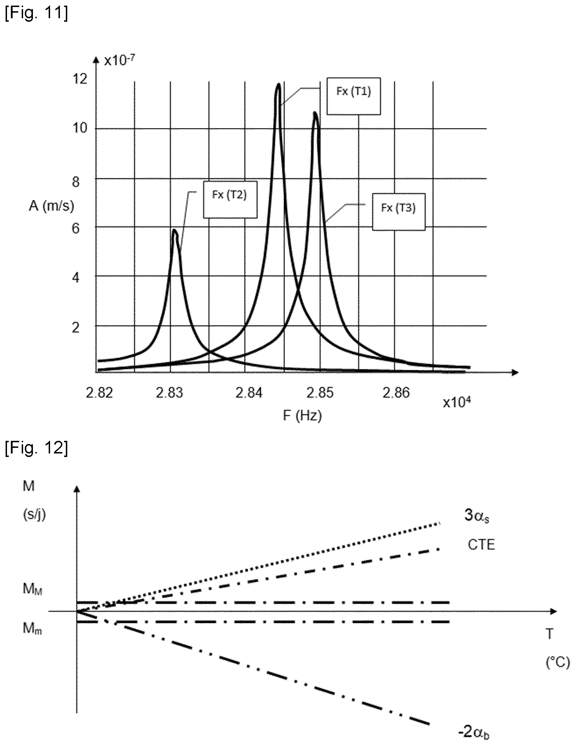

La figure 11 représente l'influence de la température sur la fréquence de résonance d'un mode de résonance particulier pour l'un du balancier ou du spiral de l'assemblage horloger de la figure 1. Sur la figure 10, les fréquences de résonance d'un même mode de résonance (un mode particulier parmi par exemple 200 modes de résonance que l'on peut typiquement identifier) sont représentées pour trois températures distinctes T1, T2, T3. On peut constater une différence de valeur de la fréquence du pic de résonance entre les trois températures.

La figure 12 montre schématiquement la marche d'une pièce d'horlogerie en fonction de la température, et la contribution des composants de l'oscillateur. Les deux termes positifs sont liés au spiral : CTE est le coefficient thermique de module d'Young et 3as est le coefficient de dilatation thermique du spiral. Le terme négatif est -2ab, qui est le coefficient de dilatation thermique de l'élément inertiel (le balancier). Grâce aux variations des fréquences de résonance en fonction de la température comme le montre la figure 11, on peut donc prédire le comportement thermique de chacun des composants de l'oscillateur avec un test vibratoire.

En effet, après une phase d'apprentissage au cours de laquelle on mesure des caractéristiques thermiques et des fréquence de résonance sur des mêmes pièces (par mesures physiques à diverses températures ou par simulation), on peut construire un modèle de prédiction thermique pour prédire les caractéristiques thermiques d'une pièce déjà fabriquée (coefficient thermique du module de Young (CTE) et/ou coefficient de dilatation thermique du spiral, ou coefficient de dilatation thermique du balancier).

Ensuite, en considérant l'équation 6, on peut prévoir d'obtenir (par fabrication sur mesure ou correction sur mesure) l'autre composant horloger permettant d'obtenir un couple balancier-spiral constituant un oscillateur ayant une faible dérive en température, avec à tout le moins une dérive en température inférieure aux tolérances imposées. En d'autres termes, il est prévu d'ajuster les caractéristiques thermiques du composant à fabriquer pour compenser exactement le comportement thermique mesuré sur le composant horloger déjà fabriqué et mesuré.

En ce qui concerne l'étape de fabrication sur mesure ou l'étape de correction sur mesure d'une pièce déjà fabriquée, pour obtenir le composant horloger complémentaire à accoupler au composant horloger déjà fabriqué, on peut utiliser des gammes de fabrication particulières, on peut aussi utiliser des outils de simulation pour trouver une configuration géométrique qui permet de fabriquer le composant horloger complémentaire à accoupler, on peut aussi utiliser des modèles de prédiction qui fournissent en sortie des dimensions à fabriquer, à partir de la caractéristique essentielle cible reçue en entrée.

En ce qui concerne une fabrication de composants horlogers sur des plaquettes, on peut prévoir, si chacun des composants horlogers considérés est fabriqué sur une plaquette, les étapes suivantes en référence aux figures 3 et 4, et en prenant l'hypothèse que ce sont des balanciers qui sont fabriqués en premier :

- cartographier la plaquette 21 en identifiant l'inertie de chaque balancier 20 de la plaquette 21,
- calculer une raideur de spiral 30 pour chaque balancier 20 de la plaquette 21 pour pouvoir fabriquer un oscillateur 10 ayant une fréquence d'oscillation libre prédéterminée,
- fabriquer des spiraux 30 sur une plaquette 31, ayant chacun une raideur adaptée à un balancier 20 de la plaquette 21, et ayant chacun une position sur la plaquette 31 correspondante à la position sur la plaquette 21 du balancier 20 à appairer correspondant (on peut par exemple fabriquer un masque d'illumination spécifique pour avoir une gravure spécifique sur la plaquette 31),
- associer chaque balancier 20 de la plaquette 21 à son spiral 30 correspondant sur la plaquette 31 (on peut par exemple mettre les plaquettes 21 et 31 en regard l'une de l'autre pour assembler ou pré-assembler les oscillateurs 10). On peut bien entendu prévoir un procédé similaire si ce sont les spiraux 30 qui sont fabriqués en premier.

Alternativement, toujours dans l'hypothèse que ce sont des balanciers qui sont fabriqués en premier, et dans l'hypothèse complémentaire où l'on dispose d'une plaquette avec des ébauches de spiraux, c'est-à-dire des spiraux partiellement fabriqués, on peut également effectuer des ajustements de la raideur des spiraux par régions sur la plaquette.

Application industrielle

Un procédé de fabrication selon la présente invention est susceptible d'application industrielle.

On comprendra que diverses modifications et/ou améliorations évidentes pour l'homme du métier peuvent être apportées aux différents modes de réalisation de l'invention décrits dans la présente description sans sortir du cadre de l'invention.

En particulier, on peut noter que la méthode de mesure ou de prédiction des caractéristiques essentielles du composant déjà fabriqué est ici prévue avec une étape initiale d'excitation vibratoire et de mesure de la réponse vibratoire. Une telle méthode est avantageuse car elle peut être mise en oeuvre sur des ébauches, les risques de pollution ou de casse sont réduits. Toutefois, en complément ou en remplacement, on peut prévoir des méthodes de mesure physiques avec contact ou avec montage dans un dispositif de test classique (mesure de la raideur du spiral 30 avec un appareil de mesure de couple, mesure de l'inertie par un accouplement du balancier 20 avec un balancier d'un oscillateur de référence...). On peut aussi prévoir des mesures géométriques ou de masse.

**Revendications**

1. Procédé de fabrication d'un oscillateur horloger (10) devant présenter une fréquence d'oscillation prédéterminée et comprenant un élément inertiel, tel qu'un balancier (20), accouplé à un organe élastique de rappel, tel qu'un ressort spiral horloger (30), le procédé de fabrication comprenant les étapes consistant à :

   - (E10) fabriquer au moins partiellement au moins l'un :

     • de l'élément inertiel et
     • de l'organe élastique de rappel,

   - (E20) imposer une excitation vibratoire au dit au moins l'un :

     • de l'élément inertiel dans un état non-accouplé et
     • de l'organe élastique de rappel dans un état non-accouplé,

   - (E20) mesurer une réponse vibratoire :

     • de l'élément inertiel non-accouplé et (E30) prédire une inertie de l'élément inertiel avec une machine de prédiction d'inertie, ou
     • de l'organe élastique de rappel non-accouplé et (E30) prédire une raideur de l'organe élastique de rappel avec une machine de prédiction de raideur,

   - (E40) prévoir un appairage :

     • de l'élément inertiel ayant l'inertie prédite à l'étape précédente, en déduisant une raideur cible de l'organe élastique de rappel nécessaire pour obtenir la fréquence d'oscillation prédéterminée, et obtenir un organe élastique de rappel à appairer ayant la raideur cible en fabriquant (E45) un organe élastique de rappel ou en apportant une correction géométrique à un organe élastique de rappel déjà fabriqué, ou
     • de l'organe élastique de rappel ayant la raideur prédite à l'étape précédente, en déduisant une inertie cible de l'élément inertiel nécessaire pour obtenir la fréquence d'oscillation prédéterminée, et obtenir un élément inertiel à appairer ayant l'inertie cible en fabriquant (E45) un élément inertiel ou en apportant une correction géométrique à un élément inertiel déjà fabriqué.

2. Procédé de fabrication selon la revendication 1, comprenant une étape consistant à appairer ou accoupler :

     • l'élément inertiel ayant ladite inertie prédite avec l'organe élastique de rappel ayant la raideur cible, ou
     • l'organe élastique de rappel ayant ladite raideur prédite avec l'élément inertiel ayant l'inertie cible.

3. Procédé de fabrication selon l'une des revendications 1 ou 2, comprenant une étape, effectuée sur l'élément inertiel dans un état non-accouplé ou sur l'organe élastique dans un état non-accouplé, consistant à corriger :

     • une inertie de l'élément inertiel ayant subi l'excitation vibratoire dans un état non-accouplé, ou
     • une raideur de l'organe élastique de rappel ayant subi l'excitation vibratoire dans un état non-accouplé.

4. Procédé de fabrication selon l'une des revendications 1 à 3, dans lequel la fabrication de l'élément inertiel et/ou de l'organe élastique de rappel comprend une étape de gravure d'un substrat non-métallique pour former au moins une partie de l'élément inertiel et/ou de l'organe élastique de rappel dans une matière non-métallique.

5. Procédé de fabrication selon l'une des revendications 1 à 4, dans lequel la fabrication de l'élément inertiel et/ou de l'organe élastique de rappel comprend une étape de gravure de l'élément inertiel et/ou de l'organe élastique de rappel dans une plaquette en silicium.

6. Procédé de fabrication selon l'une des revendications 1 à 5, dans lequel l'étape d'excitation vibratoire dans un état non-accouplé de l'élément inertiel et/ou de l'organe élastique de rappel est effectuée avec l'élément inertiel et/ou l'organe élastique de rappel encore attaché à un substrat de matière première de l'élément inertiel et/ou de l'organe élastique de rappel.

7. Procédé de fabrication selon l'une des revendications 1 à 6, dans lequel l'étape d'excitation vibratoire dans un état non-accouplé de l'élément inertiel et/ou de l'organe élastique de rappel est effectuée avant détachement ou libération ou dégrappage de l'élément inertiel et/ou de l'organe élastique de rappel d'un substrat de matière première de l'élément inertiel et/ou de l'organe élastique de rappel.

8. Procédé de fabrication selon l'une des revendications 1 à 7, dans lequel l'étape de fabrication de l'élément inertiel et/ou de l'organe élastique de rappel, commencée avant l'étape d'excitation vibratoire, est terminée ou achevée après l'étape d'excitation vibratoire.

9. Procédé de fabrication selon l'une des revendications 1 à 8, dans lequel:

   • l'étape consistant à obtenir un organe élastique de rappel à appairer ayant la raideur cible comprend une étape consistant à ajouter ou retirer de la matière d'un organe élastique de rappel déjà fabriqué, ou
   • l'étape consistant à obtenir un élément inertiel à appairer ayant l'inertie cible comprend une étape consistant à ajouter ou retirer de la matière d'un élément inertiel déjà fabriqué.

10. Procédé de fabrication selon l'une des revendications 1 à 9, dans lequel l'étape d'excitation vibratoire est effectuée en plaçant l'élément inertiel dans un état non-accouplé ou l'organe élastique de rappel dans un état non-accouplé en regard d'une source d'excitation acoustique.

11. Procédé de fabrication selon l'une des revendications 1 à 10, dans lequel l'étape d'excitation vibratoire est effectuée en appliquant à l'élément inertiel dans un état non-accouplé ou à l'organe élastique de rappel dans un état non-accouplé une excitation vibratoire variable au cours du temps pour couvrir une plage fréquentielle prédéterminée.

12. Procédé de fabrication selon la revendication 11, dans lequel la plage fréquentielle s'étend sur une plage de fréquence allant de 0 Hz à 500 kHz, et/ou de 0 Hz à 100 kHz, et/ou de 100 kHz à 200 kHz, et/ou de 200 kHz à 300 kHz, et/ou de 300 kHz à 400 kHz, et/ou de 400 kHz à 500 kHz, de préférence de 5 kHz à 150 kHz, plus préférentiellement de 5 kHz à 100 kHz, et très préférentiellement de 10 kHz à 80 kHz.

13. Procédé de fabrication selon l'une des revendications 1 à 12, dans lequel l'étape de mesure d'une réponse vibratoire comprend une étape consistant à identifier au moins une caractéristique de fréquence de résonance, telle qu'un pic de résonance, de l'élément inertiel dans un état non-accouplé ou de l'organe élastique de rappel dans un état non-accouplé, lors de l'excitation vibratoire ou en réponse à l'excitation vibratoire.

14. Procédé de fabrication selon l'une des revendications 1 à 13, dans lequel :

   • l'étape de prédiction de l'inertie de l'élément inertiel avec une machine de prédiction d'inertie,
   • l'étape de prédiction de la raideur de l'organe élastique de rappel avec une machine de prédiction de raideur,

   est effectuée avec la mise en oeuvre d'une formule polynomiale, et/ou avec la mise en oeuvre d'une classification effectuée par exemple par un réseau de neurones et/ou avec la mise en oeuvre d'une classification basée sur un partitionnement en k-moyennes ou en k-médianes.

15. Procédé de fabrication selon l'une des revendications 1 à 14, dans lequel :

   • l'étape consistant à obtenir un organe élastique de rappel à appairer ayant la raideur cible, ou
   • l'étape consistant à obtenir un élément inertiel à appairer ayant l'inertie cible,

   est effectuée après respectivement :

   • l'étape consistant à prédire une inertie de l'élément inertiel avec une machine de prédiction d'inertie, ou
   • l'étape consistant à prédire une raideur de l'organe élastique de rappel avec une machine de prédiction de raideur.

**16.** Procédé de fabrication selon l'une des revendications 1 à 15, comprenant les étapes consistant à :

- fabriquer sur une première plaquette :

• une pluralité d'éléments inertiels ou
• une pluralité d'organes élastiques de rappel,

- imposer l'excitation vibratoire et faire la mesure de la réponse vibratoire :

• sur au moins une partie de la pluralité d'éléments inertiels attachés à la première plaquette, de sorte à prédire une inertie pour chacun de la pluralité d'éléments inertiels et déduire une raideur cible de l'organe élastique de rappel nécessaire pour obtenir la fréquence d'oscillation prédéterminée ou
• sur au moins une partie de la pluralité d'organes élastiques de rappel attachés à la première plaquette de sorte à prédire une raideur pour chacun de la pluralité d'organes élastiques de rappel et déduire une inertie cible de l'élément inertiel nécessaire pour obtenir la fréquence d'oscillation prédéterminée pour chacun de la pluralité d'organes élastiques de rappel,

- prévoir un appairage :

• pour chacun de la pluralité d'éléments inertiels ayant l'inertie prédite à l'étape précédente, en déduisant une raideur cible de l'organe élastique de rappel nécessaire pour obtenir la fréquence d'oscillation prédéterminée, ou
• pour chacun de la pluralité d'organes élastiques de rappel ayant la raideur prédite à l'étape précédente, en déduisant une inertie cible de l'élément inertiel nécessaire pour obtenir la fréquence d'oscillation prédéterminée,

- fabriquer sur une deuxième plaquette :

• une pluralité d'organes élastiques de rappel où chaque organe élastique de rappel est agencé sur la deuxième plaquette à une position correspondante à une position sur la première plaquette de l'élément inertiel prévu pour son appairage, ou
• une pluralité d'éléments inertiels où chaque élément inertiel est agencé sur la deuxième plaquette à une position correspondante à une position sur la première plaquette de l'organe élastique de rappel prévu pour son appairage.

**17.** Procédé de fabrication selon la revendication 16, comprenant une étape consistant à mettre en regard la première plaquette avec la deuxième plaquette pour prépositionner chaque composant de la première plaquette en regard du composant à appairer correspondant de la deuxième plaquette.

**18.** Procédé de fabrication selon la revendication 16, comprenant une étape consistant à :

- associer ou assembler au moins un composant de la première plaquette encore attaché à la première plaquette avec le composant à appairer correspondant de la deuxième plaquette, et de préférence encore attaché à la deuxième plaquette, ou
- détacher au moins un composant de la première plaquette et le composant à appairer correspondant de la deuxième plaquette pour les associer.

**19.** Procédé de fabrication d'un oscillateur horloger (10) devant présenter une fréquence d'oscillation prédéterminée et/ou un coefficient thermique (CT) d'oscillateur prédéterminé, et comprenant un élément inertiel, tel qu'un balancier (20), accouplé à un organe élastique de rappel, tel qu'un ressort spiral horloger (30), le procédé de fabrication comprenant les étapes consistant à :

- (E10) fabriquer au moins partiellement au moins l'un :

• de l'élément inertiel et
• de l'organe élastique de rappel,

- (E20) imposer une excitation vibratoire au dit au moins l'un :

• de l'élément inertiel dans un état non-accouplé et
• de l'organe élastique de rappel dans un état non-accouplé,

- (E20) mesurer une réponse vibratoire :

• de l'élément inertiel non-accouplé et prédire (E30) un coefficient de dilatation thermique de l'élément inertiel avec une machine de prédiction de coefficient thermique, et/ou
• de l'organe élastique de rappel non-accouplé et prédire (E30) un coefficient thermique du module de Young (CTE) de l'organe élastique de rappel et/ou un coefficient de dilatation thermique de l'organe élastique de rappel avec une machine de prédiction de coefficient thermique,

- (E40) prévoir un appairage :

• de l'élément inertiel ayant le coefficient de dilatation thermique prédit à l'étape précédente, en déduisant un coefficient thermique du module de Young (CTE) cible de l'organe élastique de rappel et/ou un coefficient de dilatation thermique cible de l'organe élastique de rappel pour obtenir le coefficient thermique (CT) d'oscillateur prédéterminé, et obtenir un organe élastique de rappel à appairer ayant le coefficient thermique du module de Young (CTE) cible et/ou le coefficient de dilatation thermique cible de l'organe élastique de rappel en fabriquant (E45) un organe élastique de rappel ou en apportant une correction géométrique à un organe élastique de rappel déjà fabriqué, ou
• de l'organe élastique de rappel ayant le coefficient thermique du module de Young (CTE) et/ou le coefficient de dilatation thermique prédit à l'étape précédente, en déduisant un coefficient de dilatation thermique cible de l'élément inertiel pour obtenir le coefficient thermique (CT) d'oscillateur prédéterminé, et obtenir un élément inertiel à appairer ayant le coefficient de dilatation thermique cible en fabriquant (E45) un élément inertiel ou en apportant une correction géométrique à un élément inertiel déjà fabriqué.

[Fig. 1]

[Fig. 2]

| | | |
|---|---|---|
| E10 | | |
| E20 | | |
| E30 | I - CTb | R - CTs - CTE |
| E40 | $R_c$ ? $CTs_c$ ? $CTE_c$ ? | $I_c$ ? $CTb_c$ ? |
| E45 | | |

[Fig. 3]

[Fig. 4]

[Fig. 5]

[Fig. 6]

[Fig. 7]

[Fig. 8]

[Fig. 9]

[Fig. 10]

EP 4 614 242 A1

[Fig. 11]

[Fig. 12]

23

EP 4 614 242 A1

Europäisches
Patentamt

European
Patent Office

Office européen
des brevets

## RAPPORT DE RECHERCHE EUROPEENNE

**Numéro de la demande**

EP 24 16 1245

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2024/017847 A1 (RICHEMONT INT SA [CH]) 25 janvier 2024 (2024-01-25) | 1-15,19 | INV. G04B17/06 |
| Y | * le document en entier * | 1-15,19 | G04D7/08 |
| A | | 16-18 | G04D7/10 |
| | ----- | | G04D7/12 |
| Y | EP 3 534 222 A1 (ROLEX SA [CH]) 4 septembre 2019 (2019-09-04) | 1-15,19 | |
| A | * abrégé * * alinéas [0005] - [0017], [0028], [0029] * * alinéas [0055], [0056] * | 16-18 | ADD. B81C99/00 |
| | ----- | | |
| A | EP 4 031 936 B1 (RICHEMONT INT SA [CH]) 8 novembre 2023 (2023-11-08) * abrégé * * figures 5,6 * * alinéas [0035], [0036] * | 16-18 | |
| | ----- | | |

**DOMAINES TECHNIQUES RECHERCHES (IPC)**

G04B
G04F
B82B
B81C
G04D

Le présent rapport a été établi pour toutes les revendications

| Lieu de la recherche | Date d'achèvement de la recherche | Examinateur |
|---|---|---|
| Munich | 3 juillet 2024 | Poizat, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

24

Europäisches
Patentamt

European
Patent Office

Office européen
des brevets

## REVENDICATIONS DONNANT LIEU AU PAIEMENT DE TAXES

La présente demande de brevet européen comportait lors de son dépôt les revendications dont le paiement était dû.

☐ Une partie seulement des taxes de revendication ayant été acquittée dans les délais prescrits, le présent rapport de recherche européenne a été établi pour les revendications pour lesquelles aucun paiement n'était dû ainsi que pour celles dont les taxes de revendication ont été acquittées, à savoir les revendication(s):

☐ Aucune taxe de revendication n'ayant été acquittée dans les délais prescrits, le présent rapport de recherche européenne a été établi pour les revendications pour lesquelles aucun paiement n'était dû.

## ABSENCE D'UNITE D'INVENTION

La division de la recherche estime que la présente demande de brevet européen ne satisfait pas à l'exigence relative à l'unité d'invention et concerne plusieurs inventions ou pluralités d'inventions, à savoir:

voir feuille supplémentaire B

☐ Toutes les nouvelles taxes de recherche ayant été acquittées dans les délais impartis, le présent rapport de recherche européenne a été établi pour toutes les revendications.

☒ Comme toutes les recherches portant sur les revendications qui s'y prêtaient ont pu être effectuées sans effort particulier justifiant une taxe additionnelle, la division de la recherche n'a sollicité le paiement d'aucune taxe de cette nature.

☐ Une partie seulement des nouvelles taxes de recherche ayant été acquittée dans les délais impartis, le présent rapport de recherche européenne a été établi pour les parties qui se rapportent aux inventions pour lesquelles les taxes de recherche ont été acquittées, à savoir les revendications:

☐ Aucune nouvelle taxe de recherche n'ayant été acquittée dans les délais impartis, le présent rapport de recherche européenne a été établi pour les parties de la demande de brevet européen qui se rapportent à l'invention mentionnée en premier lieu dans les revendications, à savoir les revendications:

☐ Le present rapport supplémentaire de recherche européenne a été établi pour les parties de la demande de brevet européen qui se rapportent a l'invention mentionée en premier lieu dans le revendications (Règle 164 (1) CBE)

Europäisches
Patentamt

European
Patent Office

Office européen
des brevets

## ABSENCE D'UNITÉ D'INVENTION
## FEUILLE SUPPLÉMENTAIRE B

Numéro de la demande

EP 24 16 1245

La division de la recherche estime que la présente demande de brevet européen ne satisfait pas à l'exigence relative à l'unité d'invention et concerne plusieurs inventions ou pluralités d'inventions, à savoir :

1. revendications: 1-19

   Procédé de fabrication d'un oscillateur horloger devant présenter une fréquence d'oscillation prédéterminée, le procédé impliquant une mesure vibratoire d'au moins un élément de l'oscillateur dans un état non accouplé

1.1. revendication: 19

   Procédé de fabrication d'un oscillateur horloger devant présenter un coefficient thermique prédéterminé, le procédé impliquant une mesure vibratoire d'au moins un élément de l'oscillateur dans un état non accouplé
                              - - -

Prière de noter que toutes les inventions mentionnées sous point 1, qui ne sont pas nécessairement liées par un concept inventif commun, ont pu être recherchées sans effort particulier justifiant une taxe additionnelle.

EPO FORM P0402

**ANNEXE AU RAPPORT DE RECHERCHE EUROPEENNE
RELATIF A LA DEMANDE DE BREVET EUROPEEN NO.**

EP 24 16 1245

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-07-2024

| Document brevet cité au rapport de recherche | Date de publication | Membre(s) de la famille de brevet(s) | | Date de publication |
|---|---|---|---|---|
| WO 2024017847 A1 | 25-01-2024 | EP | 4310598 A1 | 24-01-2024 |
| | | WO | 2024017847 A1 | 25-01-2024 |
| EP 3534222 A1 | 04-09-2019 | CN | 110221531 A | 10-09-2019 |
| | | EP | 3534222 A1 | 04-09-2019 |
| | | JP | 7253405 B2 | 06-04-2023 |
| | | JP | 2019194567 A | 07-11-2019 |
| | | US | 2019271946 A1 | 05-09-2019 |
| EP 4031936 B1 | 08-11-2023 | CH | 716605 A1 | 31-03-2021 |
| | | CN | 114730154 A | 08-07-2022 |
| | | EP | 4031936 A1 | 27-07-2022 |
| | | JP | 2022547618 A | 14-11-2022 |
| | | US | 2022350255 A1 | 03-11-2022 |
| | | WO | 2021053501 A1 | 25-03-2021 |

EPO FORM P0460

Pour tout renseignement concernant cette annexe : voir Journal Officiel de l'Office européen des brevets, No.12/82